# FASCICULE DE BREVET EUROPEEN

(11) **EP 2 965 102 B1**
(45) Date de publication et mention de la délivrance du brevet: **14.12.2016**
(21) Numéro de dépôt: 14718645.6
(22) Date de dépôt: 04.03.2014
(51) Int. Cl.: G01R 31/34

(54) **PROCÉDÉ DE DÉTECTION D'UN DÉFAUT DE COURT-CIRCUIT DANS DES BOBINAGES D'UN ROTOR D'UNE MACHINE ÉLECTRIQUE TOURNANTE**
VERFAHREN ZUM ERKENNEN EINES KURZSCHLUSSFEHLERS IN DEN WINDUNGEN EINES ROTORS EINER ELEKTRISCHEN ROTATIONSMASCHINE
METHOD FOR DETECTING A SHORT-CIRCUIT FAULT IN THE WINDINGS OF A ROTOR OF A ROTATING ELECTRIC MACHINE

(30) Priorité: 05.03.2013 FR 1351982
(43) Date de publication de la demande: 13.01.2016
(73) Titulaire: Electricité de France, 75008 Paris (FR)
(72) Inventeur: JACQ, Thierry, F-93170 Bagnolet (FR); GUILLOT, Eilin, F-91420 Morangis (FR); BIET, Mélisande, F-92130 Issy Les Moulineaux (FR); DE CHILLAZ, Antoine, F-92130 Issy Les Moulineaux (FR); CHARBONNIER, Bruno, F-75011 Paris (FR)
(74) Mandataire: Cabinet Plasseraud
(86) Numéro de dépôt international: PCT/FR2014/050476
(87) Numéro de publication internationale: WO 2014/135785

(56) Documents cités:
- EP-A1- 0 608 442
- WO-A1-2009/127068
- GB-A- 2 122 749
- US-A- 4 377 784
- US-A1- 2010 295 491
- US-B1- 6 172 509
- CHANGCHANG WANG ET AL: "Interference rejection for on-line PD monitoring of power transformers", ELECTRICAL INSULATION, 1998. CONFERENCE RECORD OF THE 1998 IEEE INTERN ATIONAL SYMPOSIUM ON ARLINGTON, VA, USA 7-10 JUNE 1998, NEW YORK, NY, USA,IEEE, US, vol. 1, 7 juin 1998 (1998-06-07), pages 24-27, XP010290573, DOI: 10.1109/ELINSL.1998.704640 ISBN: 978-0-7803-4927-8

## Description

La présente invention se rapporte à un procédé de détection d'un défaut de court-circuit dans des bobinages d'un rotor d'une machine électrique tournante telle qu'un alternateur, utilisant des mesures de flux électromagnétique réalisées par une sonde disposée dans un entrefer de la machine électrique, le procédé comprenant les étapes suivantes :
- l'échantillonnage d'un signal de sonde mesuré par la sonde sur au moins un tour du rotor ;
- la génération d'au moins un signal de différence représentatif de la différence point par point entre une superposition des mesures du signal de sonde (Vs) relatives à deux pôles distincts du rotor, afin de comparer pôle à pôle le signal de sonde mesuré ; et
- le traitement dudit signal de différence de façon à pouvoir déterminer la présence éventuelle d'un défaut de court-circuit.

Dans le but de suivre l'état diélectrique des bobinages dans les rotors des machines synchrones d'un parc de centrales nucléaires ou de centrales thermiques, de nombreux exploitants dont la demanderesse ont installé des sondes comprenant des capteurs de flux dans l'entrefer des machines. Depuis quelques années, les turboalternateurs du parc nucléaire de la demanderesse sont équipés chacun d'une telle sonde, qui a généralement été installée à l'occasion de la mise à l'arrêt de la machine pour son inspection générale une fois tous les dix ans. Une sonde comprend dans la plupart des cas deux bobines de détection de flux. Un modèle de sondes peut posséder une bobine radiale et une bobine tangentielle, ou plus rarement deux bobines radiales dont l'une est en secours de l'autre en cas de défaillance telle qu'une rupture de la bobine. Le risque de défaillance d'une bobine est cependant extrêmement faible, par conséquent les sondes à bobines radiale et tangentielle sont préférées par la demanderesse.

Typiquement, une bobine radiale et une bobine tangentielle d'une même sonde de flux sont disposées l'une à côté de l'autre à l'extrémité d'un boitier formé par une canule qui traverse le stator dans une direction radiale. La bobine radiale, sensible au flux radial, est orientée selon l'axe de la canule, tandis que la bobine tangentielle est orientée perpendiculairement à l'axe de la canule et dans un plan radial contenant l'axe du rotor pour être sensible au flux tangentiel. Un exemple de disposition des deux bobines radiale et tangentielle d'une sonde de flux est décrit dans le brevet américain US3506914. Lorsque la machine est en fonctionnement, les variations du champ magnétique dans l'entrefer engendrent une force électromotrice aux bornes de chacune des deux bobines. La tension aux bornes de chaque bobine peut être mesurée sur une durée correspondant à au moins un tour du rotor. Le signal mesuré est traité afin de rechercher d'éventuels indices révélateurs de la présence d'un court-circuit dans le bobinage du rotor. Un avantage d'une telle technique est de permettre un diagnostic en ligne, c'est-à-dire avec la machine en fonctionnement et sans perturber le fonctionnement.

Un procédé de détection tel que défini en introduction ci-dessus est connu du brevet européen EP0608442B1, et notamment du mode de réalisation correspondant à la figure 2 du brevet. Un exemple d'une sonde possédant une bobine radiale et une bobine tangentielle est décrit en référence à la figure 5 et la figure 6 du brevet. Un signal d'entrée constitué de trains d'impulsions est mesuré aux bornes d'une bobine de la sonde dans un alternateur à deux pôles. Ce signal est traité par une unité de conditionnement et un convertisseur numérique d'échantillonnage ainsi qu'un synchronisateur, puis par une unité de traitement de données qui amène dans deux mémoires le signal numérisé de deux trains d'impulsions successifs A et B.

L'unité de traitement de données comprend une section de calcul pour mesurer les différences entre les amplitudes des impulsions correspondantes des deux trains d'impulsions successifs qui sont comparés entre eux par superposition. Une valeur moyenne des différences des amplitudes est calculée dans le temps, sur une durée correspondant à plusieurs périodes du signal. Cette valeur moyenne est calculée pour chaque paire d'impulsions correspondantes, c'est-à-dire l'impulsion d'un train d'impulsions A et l'impulsion correspondante d'un train d'impulsions B. Si pour une paire d'impulsions correspondantes la moyenne des différences ne tend pas vers zéro mais reste quasiment constante, cela signifie qu'une des deux impulsions présente une amplitude anormalement basse qui n'est pas due à des perturbations aléatoires du signal. La présence d'un court-circuit dans le bobinage du rotor, au niveau de l'encoche du rotor correspondant à l'impulsion d'amplitude anormale, est alors très probable.

Le procédé de détection décrit dans le brevet EP0608442B1 présente néanmoins des inconvénients. En particulier, afin autant que possible de s'affranchir du bruit de la mesure, la moyenne des différences des amplitudes pour chaque paire d'impulsions correspondantes doit être calculée sur une durée de mesure représentant un relativement grand nombre de tours du rotor, typiquement au moins une dizaine de tours. Or, le niveau des tensions induites dans les bobines de la sonde est fonction du facteur de charge de la machine. En effet, dans le cas par exemple d'un alternateur, plus la puissance demandée est importante, plus le flux magnétique est grand, et donc plus la tension induite dans chaque bobine d'une sonde de flux est élevée. Avec une mesure sur un grand nombre de tours du rotor, les mesures de la sonde de flux sont fortement influencées par une possible variation du facteur de charge et de la fréquence du réseau durant la mesure. La moyenne des différences des amplitudes d'une paire d'impulsions peut alors fluctuer sans tendre vers zéro même en l'absence de défaut de court circuit dans le bobinage du rotor. Il peut donc s'avérer difficile de distinguer une paire d'impulsions pour laquelle une moyenne des différences des amplitudes traduit un véritable défaut du bobinage du rotor.

La présente invention vise à améliorer la fiabilité d'un tel procédé de détection d'un défaut de court-circuit, et vise notamment à permettre que la sensibilité de la détection s'adapte automatiquement à la machine à surveiller.

A cet effet, l'invention a pour objet un procédé de détection tel que défini en introduction, caractérisé en ce que ladite étape de traitement du signal de différence comprend les étapes suivantes :
- le calcul d'une valeur moyenne algébrique et d'un écart type dudit signal de différence ;
- la détermination d'une amplitude maximale du signal de sonde ;
- le calcul d'une valeur de seuil de décision, prenant en compte ledit écart type du signal de différence ainsi que ladite amplitude maximale du signal de sonde ;
- la détermination d'une plage de valeurs de diagnostic centrée sur ladite valeur moyenne algébrique et ayant pour largeur deux fois ladite valeur du seuil de décision ;
- le repérage d'au moins un éventuel point d'alerte correspondant à une valeur dudit signal de différence qui se situe en dehors de ladite plage de valeurs de diagnostic ;
- le signalement d'un dit défaut de court-circuit dès lors qu'au moins un dit point d'alerte est repéré.

Grâce à ces dispositions, le seuil de décision s'adapte à l'amplitude maximale du signal mesuré par la sonde. De ce fait, il n'est pas nécessaire d'adapter spécialement le traitement du signal de différence à la machine particulière sur laquelle le procédé de détection est mis en oeuvre. En outre, bien que le facteur de charge de la machine ait une influence sur l'amplitude maximale du signal de sonde, l'adaptation automatique du seuil de décision à cette amplitude permet que le facteur de charge ne gêne pas la distinction de pics significatifs du signal de différence pour détecter de façon fiable un défaut de court-circuit. Par ailleurs, comme expliqué plus loin, à partir d'un échantillonnage d'un signal de sonde mesuré sur une durée correspondant à seulement un tour un quart du rotor, le procédé de détection peut déterminer la présence d'un défaut de court-circuit dans le bobinage du rotor. Un échantillonnage sur une durée aussi courte permet que le signal mesuré soit beaucoup moins sensible aux possibles variation du facteur de charge et de la fréquence du réseau durant la mesure, en comparaison avec le procédé décrit dans le brevet EP0608442B1.

Dans des modes de réalisation préférés d'un procédé de détection selon l'invention, on a recours notamment à l'une ou l'autre des dispositions suivantes :
on identifie un groupe fiable de points d'alerte dès lors qu'il est repéré au moins un nombre prédéterminé de points d'alerte consécutifs et un dit défaut de court-circuit est signalé seulement si un dit groupe fiable de points d'alerte est identifié ;
ledit signal de sonde est enregistré sur un nombre de tours du rotor compris entre 1,25 et 2,5 ;
la fréquence d'échantillonnage du signal de sonde est au moins égale à 50 KHz, et l'échantillonnage utilise un convertisseur analogique/numérique ayant une résolution d'au moins 12 bits ;
ladite valeur de seuil de décision (S) vérifie la relation suivante :
   S = k.√(e²+(A/K)²), où k et K sont des nombres entiers, e est l'écart type du signal de différence, et A est l'amplitude maximale du signal de sonde ;
   k est égal à 8 et K est compris entre 180 et 220 ;
si un signal de top-tour est disponible on identifie dans le signal de sonde chaque instant correspondant à un top-tour ; et si un signal de top-tour n'est pas disponible, on construit ce signal par auto-corrélation des mesures du signal de sonde effectuées sur au moins 1,25 tours, en connaissance de la fréquence théorique du réseau et du nombre de paires de pôles de la machine électrique, le top-tour étant identifié par les maxima de corrélation ;
on découpe le signal de sonde par tours sur chaque période entre deux top-tours consécutifs, et on procède à un ré-échantillonnage du signal afin que chaque tour découpé ait la même longueur en terme de nombre de points de mesure que la longueur théorique d'un tour sur la base de la fréquence théorique du réseau ;
un tour découpé du signal de sonde est divisé par pôles en créant des tronçons polaires ayant chacun la longueur dudit tour découpé divisée par le nombres de pôles ;
le calcul de la valeur moyenne et de l'écart type dudit signal de différence est effectué sur un signal de différence écrêté obtenu en supprimant du signal de différence des points situés dans des plages de valeurs extrêmes du signal ;
on supprime du signal de différence les points correspondant aux valeurs algébriques qui sont comprises entre une valeur extrême haute du signal de différence et cette valeur extrême haute diminuée d'un certain pourcentage d'écrêtage de l'amplitude maximale du signal de différence, ainsi que les points correspondant aux valeurs qui sont comprises entre une valeur extrême basse du signal de différence et cette valeur extrême basse augmentée dudit pourcentage d'écrêtage de l'amplitude maximale du signal de différence, ledit pourcentage d'écrêtage étant compris entre 2% et 20% ;
on génère un nombre Ns de signaux de différence, Ns vérifiant la relation Ns = Np - 1 où Np est le nombre de pôles de la machine électrique, et un dit défaut de court-circuit est signalé dès lors que le traitement desdits signaux de différence fait apparaître au moins un dit point d'alerte sur au moins un dit signal de différence ;
deux tronçons polaires consécutifs sont comparés entre eux pour générer un dit signal de différence.

D'autres caractéristiques et avantages ressortent de la description qui va suivre d'exemples non limitatifs de modes de réalisation, en référence aux figures dans lesquelles :

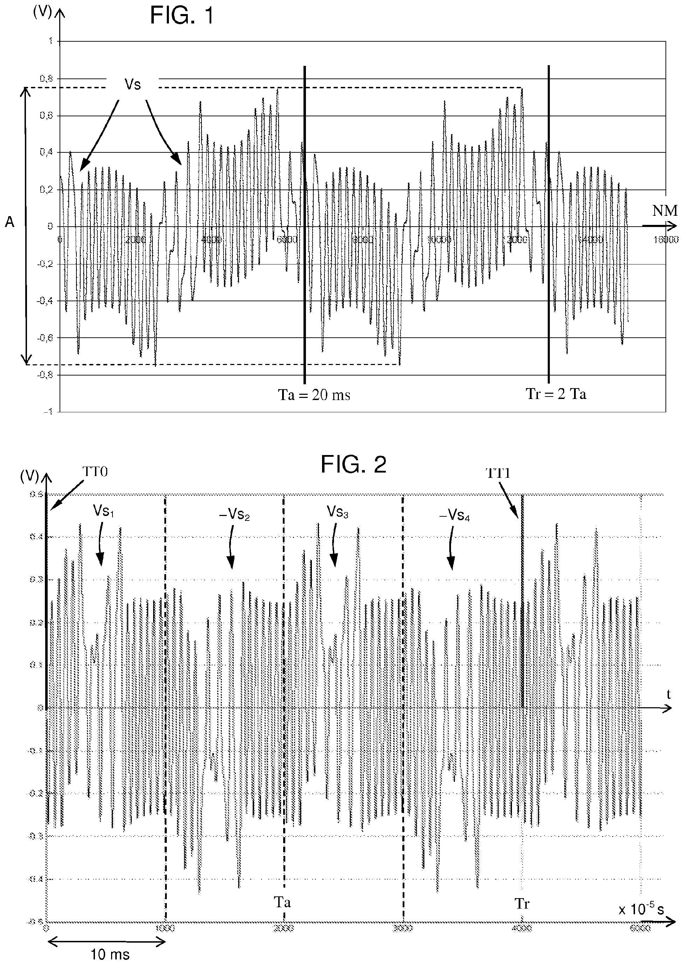

La FIG.1 représente un exemple du signal de la tension issue d'une bobine d'une sonde de flux d'entrefer ;
La FIG.2 représente un autre exemple d'un signal fourni par une sonde de flux, et illustre le marquage d'un signal de top-tour et le découpage d'un tour en quatre tronçons polaires ;

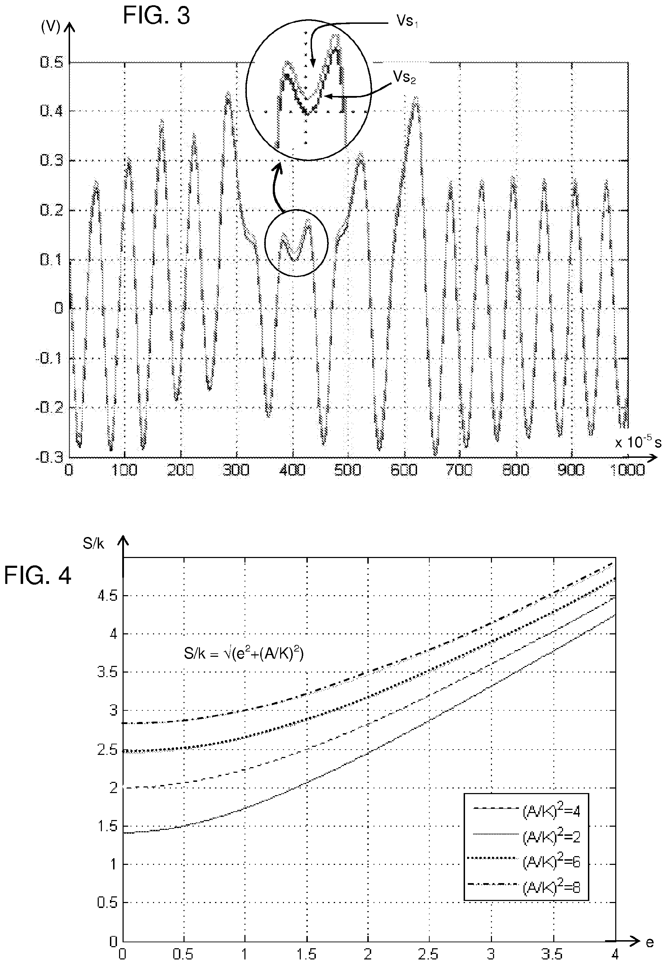

La FIG.3 représente la superposition des signaux des deux premiers tronçons polaires du signal de sonde de la FIG.2, avec un agrandissement d'une zone de points où des écarts entre les deux signaux apparaissent ;
La FIG.4 représente des courbes de seuils de décision en fonction de l'écart type du signal de différence, pour quelques exemples de différentes valeurs de l'amplitude maximale du signal de sonde ;

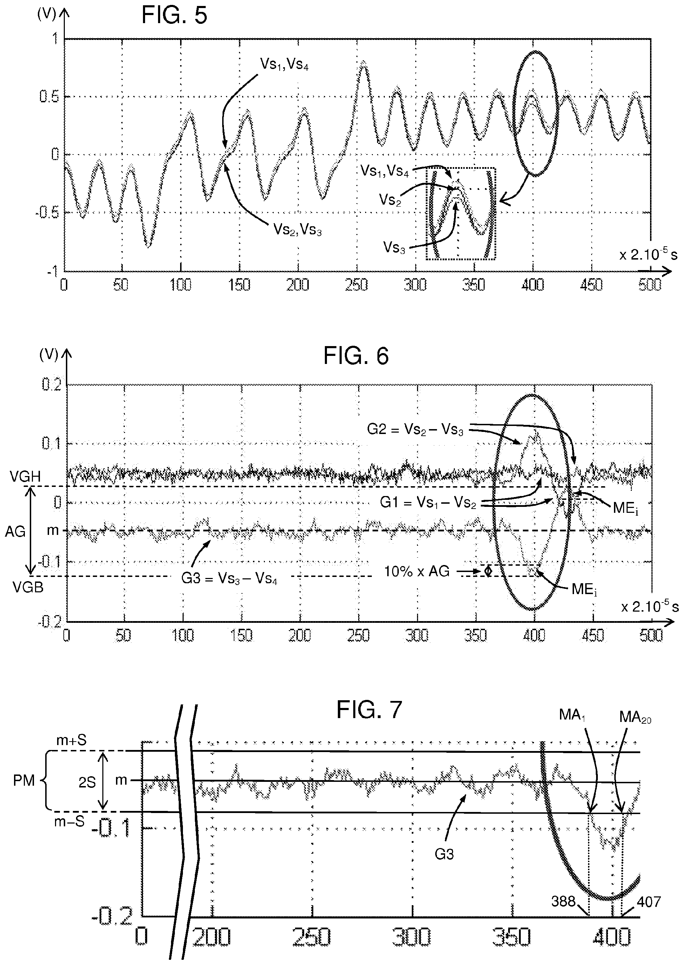

La FIG.5 représente un autre exemple de superposition de signaux de tronçons polaires d'un signal de sonde, dans lequel des écarts entre les signaux laissent suspecter la présence d'un défaut de court-circuit ;
La FIG.6 représente des signaux de différence pôle à pôle générés par des comparaisons des signaux superposés de la FIG.5 ;
La FIG.7 représente le repérage d'une série de points d'alerte correspondant à des valeurs d'un signal de différence de la FIG.6 qui se situent en dehors d'une plage de diagnostic ;

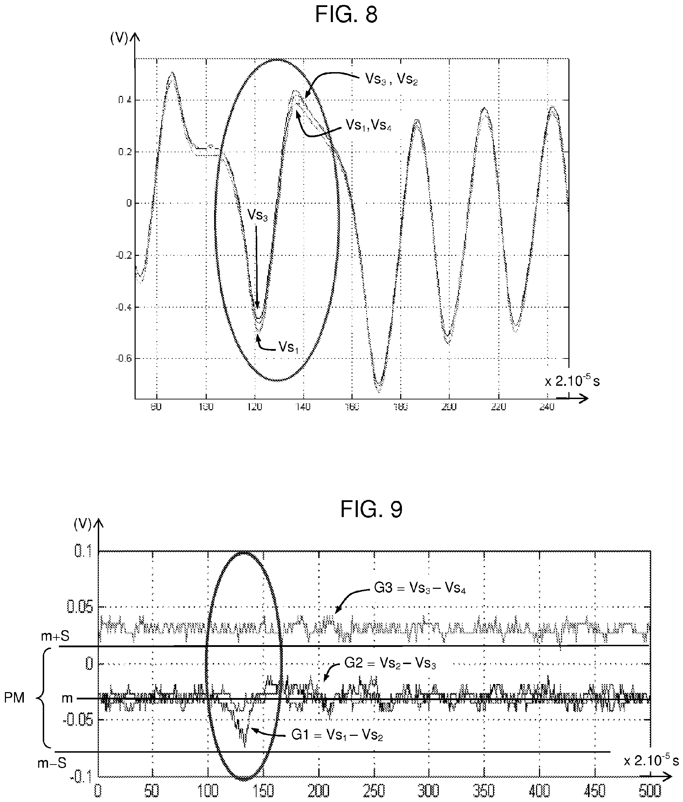

La FIG.8 représente un autre exemple de superposition de signaux de tronçons polaires d'un signal de sonde, dans un cas tangent où un défaut réel de court-circuit n'est pas détecté à cause notamment d'une quantification insuffisante de la mesure ; La FIG.9 représente des signaux de différence pôle à pôle générés par des comparaisons des signaux superposés de la FIG.8, et illustre l'effet de la quantification insuffisante de la mesure sur le niveau du seuil de décision.

Sur la FIG.1 est représenté un exemple d'une mesure échantillonnée du signal Vs de la tension issue d'une des deux bobines d'une sonde de flux d'entrefer, la mesure étant effectuée pendant 1,25 tour du rotor de l'alternateur. Une telle mesure de sonde de flux peut être relevée par exemple automatiquement entre une fois toutes les 5 minutes et une fois toutes les 24 heures. La graduation en abscisse correspond au nombre NM de points de mesure générés par l'échantillonnage du signal de la sonde. L'instant initial de la mesure, ainsi que l'angle initial du rotor, sont quelconques. Le signal présente une allure périodique de période apparente Ta, chaque période apparente couvrant une succession de deux trains d'impulsions qui apparaissent inversés l'un par rapport à l'autre. Chaque train d'impulsions correspond aux variations du flux magnétique dans l'entrefer lors du passage des encoches d'un pôle devant la sonde. Le rotor possédant quatre pôles, la période apparente Ta correspond à un demi-tour du rotor et est égale à 20 ms si la fréquence du réseau est égale à 50 Hz. Un tour complet du rotor s'effectue sur une période Tr égale au double de la période apparente Ta.

Dans le cas où tous les pôles sont sains, les trains d'impulsions des pôles pairs et ceux des pôles impairs sont en théorie identiques, et chaque train d'impulsions d'un pôle pair est exactement l'inverse d'un train d'impulsions d'un pôle impair. L'amplitude maximale A du signal correspond donc théoriquement à l'écart entre deux valeurs extrêmes opposées de la tension mesurée, c'est-à-dire deux fois la valeur extrême positive, par exemple deux fois 0,75V dans l'exemple de la FIG.1. Sur une machine réelle, il existe une différence minime entre les flux magnétiques générés par les pôles successifs du rotor. De plus, le bruit de la mesure crée également des différences entre les flux magnétiques mesurés sur des pôles successifs. Par conséquent, les trains d'impulsions successifs ne sont pas rigoureusement identiques entre eux. La comparaison entre le signal d'un train d'impulsions et le signal d'un autre train d'impulsions, par superposition des deux trains d'impulsions redressés dans le même sens et par soustraction point à point des valeurs des deux signaux, ne donne donc pas un signal de différence parfaitement nul même avec des pôles sains. La méthode consistant à étudier un tel signal de différence, afin de détecter un éventuel défaut de court-circuit dans un pôle, présente donc la difficulté de parvenir à l'obtention d'un signal de différence dans lequel un pic révélateur du défaut pourra être distingué.

Concernant la comparaison pôle à pôle, on utilise dans la présente le terme pôle pour désigner un tronçon du signal de sonde correspondant à un quart de tour du rotor pour un rotor comprenant quatre pôles, ou à un demi tour du rotor pour un rotor comprenant deux pôles. Ce pôle ne se superpose pas nécessairement à un pôle au sens électrotechnique. En effet, on désigne par tronçon entier un tronçon du signal de sonde correspondant à un tour complet du rotor. Comme expliqué plus loin, l'instant initial de la mesure d'un tronçon entier ne correspond pas nécessairement à la séparation entre deux pôles au sens électrotechnique. On divise un tronçon entier par le nombre de pôles du rotor pour former des tronçons de signal de même longueur désignés comme tronçons polaires. Ainsi, lorsqu'on parle de comparaison pôle à pôle du signal, il s'agit de comparer les mesures respectives du signal de deux tronçons polaires distincts.

Afin de ne pas fausser la comparaison pôle à pôle du signal de la sonde de flux, il convient de recaler au mieux les différents tronçons polaires correspondant aux pôles, de façon à ce que deux points comparés entre deux tronçons polaires représentent la comparaison des mesures du flux à des positions angulaires du rotor qui correspondent exactement l'une à l'autre sur les deux pôles comparés. Un recalage imparfait entre les tronçons polaires augmente artificiellement les différences point à point dans la comparaison pôle à pôle, ce qui entraîne généralement un fort écart-type du signal de différence et empêche souvent de distinguer un pic révélateur d'un défaut.

Afin de permettre un bon recalage entre les tronçons polaires, il faut identifier précisément sur le signal de sonde le point de top-tour correspondant exactement à un tour du rotor, afin d'identifier un tronçon entier dont la longueur correspond exactement à un tour. Un signal de top-tour peut être disponible ou non, selon le matériel de mesure équipant la machine tournante. Par exemple, le signal de top-tour pourra être fourni par un capteur prévu à cet effet et être utilisé s'il est suffisamment précis. En l'absence d'un tel signal de top-tour disponible, il faut le construire à partir du signal de sonde. La connaissance de la fréquence d'échantillonnage du signal de sonde et du nombre de paires de pôles de la machine permet de calculer la longueur théorique d'un tour.

Si la fréquence d'échantillonnage n'est pas connue, son estimation repose sur le fait qu'un alternateur tourne à une vitesse connue, par conséquent il existe une périodicité du signal de sonde de flux comme montré en référence à la FIG.1. Avec une fréquence du réseau de 50 Hz, une paire de pôles est vue par la sonde de flux toutes les 20 ms. En corrélant le signal avec lui-même, le premier maximum de corrélation correspond donc à une période de 20 ms. Il suffit de trouver la localisation en nombre de points de ce premier maximum et de la diviser par 20 pour obtenir la fréquence d'échantillonnage en kHz. Cette méthode permet d'exploiter les signaux en l'absence de l'information sur la fréquence d'acquisition. Cependant elle repose sur la valeur moyenne de 20 ms pour la période du réseau, or la fréquence du réseau est susceptible de varier autour de 50 Hz. Il est donc préférable de connaître a priori la fréquence d'échantillonnage de la sonde de flux. Par ailleurs, si la fréquence d'échantillonnage est inférieure à 100 kHz, une interpolation du signal peut être avantageusement réalisée pour recréer un échantillonnage à 100 kHz, ce qui permet d'avoir une précision temporelle suffisante pour la détection. L'interpolation retenue se fait dans le domaine spectral, par transformée de Fourier du signal, ajout de points (zéros au milieu) à la transformée, et transformée de Fourier inverse.

Avec le nombre p de paires de pôles, par exemple deux paires de pôles pour un alternateur d'une centrale nucléaire, ainsi que la fréquence d'échantillonnage Fe en Hz et la fréquence du réseau égale par exemple à 50 Hz, on calcule la longueur théorique d'un tour comme le nombre N de points échantillonnés sur la durée théorique d'un tour du rotor, par la relation suivante : N = Fe • p / 50. On enregistre le signal sur au moins le nombre N de points, et préférablement sur au moins 1,25 fois ce nombre N de points pour avoir une mesure sur au moins un tour un quart du rotor.

En effet, si l'enregistrement est limité au nombre N de points, c'est-à-dire à la longueur théorique d'un tour, il n'est pas certain en réalité qu'exactement un tour entier soit enregistré, du fait notamment des variations de la fréquence du réseau autour de 50 Hz. Par exemple, une fréquence du réseau égale à 50,5 Hz correspond à une durée de 19,8 ms pour un tour réel du rotor, soit un écart de 0,2 ms par rapport à la période de 20 ms correspondant à 50 Hz. Avec une fréquence d'échantillonnage par exemple égale à 100 kHz, cet écart de 0,2 ms correspond à 20 points de mesure en moins par rapport au nombre N de points. La corrélation du signal avec lui-même risque donc fort de ne présenter aucun maximum.

Une fois l'enregistrement réalisé sur au moins un tour un quart du rotor, on choisit une partie de l'enregistrement de longueur 1,25 fois le nombre N de points, puis on procède à l'auto-corrélation du signal et on recherche les maxima de cette corrélation autour des points théoriques de fin des tours. La localisation de ces maxima donne directement l'information correspondant au top-tour. On obtient en sortie un signal qui vaut 0 partout, sauf aux localisations des maxima de corrélation où il vaut 1. Il peut être préférable de réaliser l'enregistrement sur 2,5 tours du rotor, afin de pouvoir étudier plusieurs parties d'enregistrement chacune de longueur 1,25 fois le nombre N de points, ce qui permet ensuite de choisir une partie d'enregistrement pour laquelle l'auto-corrélation du signal présenterait éventuellement des maxima plus précis en comparaison avec une autre partie d'enregistrement.

Un exemple de marquage d'un signal de top-tour est représenté sur la FIG.2. Il s'agit dans cet exemple d'une mesure d'un signal de sonde de flux sur une machine différente de celle correspondant à la FIG.1 1 et dont le rotor possède également quatre pôles. L'amplitude maximale du signal est plus petite que dans l'exemple précédent. L'instant initial de la mesure ne correspond pas à la séparation entre deux pôles au sens électrotechnique, puisqu'il se situe ici aux alentours du milieu d'un train d'impulsions. La fréquence d'échantillonnage étant fixée à 100 kHz, le nombre théorique N de points sur un tour à compter de l'instant initial de la mesure est égal à 4000, puisque la période Tr de rotation du rotor est égale à 40 ms pour une fréquence du réseau égale à 50 Hz. Le point de top-tour TT1, qui correspond à un tour à compter du top-tour initial TT0 fixé sur le premier point de la mesure, peut être indiqué grâce à un capteur prévu à cet effet sur la machine, ou être trouvé par la méthode susmentionnée de repérage d'un maximum de corrélation. Ce point de top-tour TT1 ne se situe pas nécessairement exactement sur le point n° N correspondant à la durée théorique d'un tour. En effet, le point TT1 se situera généralement dans une plage de variation de quelques points autour du point n° N théorique du fait d'une variation minime de la fréquence du réseau autour de 50 Hz. Ainsi, du fait de la variation de la fréquence du réseau, une mesure du signal de sonde sur plusieurs tours fera généralement apparaître des tours de rotation réelle qui n'ont pas exactement la même longueur en terme de nombre de points de mesure entre deux points consécutifs de top-tours.

Afin de pouvoir effectuer une comparaison précise des pôles, il est important de ré-échantillonner l'enregistrement effectué du signal de sonde mesuré, afin que chaque tour découpé, c'est-à-dire chaque tronçon entier de la mesure du signal de sonde sur une durée correspondant à un tour, ait la même longueur en terme de nombre de points de mesure que la longueur d'un tour sur la base de la fréquence théorique du réseau. Par exemple, si le point de top-tour TT1 sur la FIG.2 se situe entre les points n° 3990 et n° 3999 de la mesure, le signal de sonde enregistré entre les deux points de top-tour TT0 et TT1 sera ré-échantillonné de façon à ce que le point de top-tour TT1 se situe exactement au point n° 4000 de la mesure. Si cette étape de ré-échantillonnage n'est pas effectuée, il apparaît généralement des décalages temporels dans la superposition des signaux des pôles, qui peuvent entraîner des différences pôle à pôle importantes. Ces différences faussent le calcul du signal de différence, surtout lors des fronts raides du signal de force électromotrice mesuré par la sonde.

Une fois que le signal a été découpé en au moins un tour, c'est-à-dire en au moins un tronçon entier correspondant à un tour comme décrit ci-dessus, un tour découpé est divisé en tronçons polaires représentant chacun un pôle, en divisant la longueur du tour découpé, c'est-à-dire la longueur du tronçon entier, par le nombre de pôles du rotor. Dans l'exemple de la FIG.2, le rotor possédant quatre pôles, chaque pôle correspond à un tronçon de signal comprenant exactement 1000 points de mesures à une fréquence d'échantillonnage de 100 kHz, soit une durée de 10 ms par pôle. Une fois les pôles identifiés en tronçons polaires du signal de sonde, afin de pouvoir comparer les pôles deux à deux par superposition, il convient de changer le signe des signaux correspondants aux pôles pairs pour qu'ils soient dans le même sens que les pôles impairs. Par exemple, le deuxième pôle identifié, c'est-à-dire le deuxième tronçon polaire du signal de sonde, est désigné arbitrairement comme un pôle pair et correspond à un tronçon de signal -Vs₂ qui est quasiment l'inverse du tronçon de signal Vs₁ correspondant au premier tronçon polaire identifié. Le changement de signe du tronçon de signal -Vs₂ génère un tronçon de signal Vs₂ qui en théorie se superpose exactement au tronçon de signal Vs₁ pour une machine sans défaut. En d'autres termes, tous les pôles (tronçons polaires) se superposent exactement les uns sur les autres en théorie pour une machine sans défaut.

Sur la FIG.3, on a représenté la superposition des tronçons de signaux Vs₁ et Vs₂ correspondant aux deux premiers tronçons polaires. Les pôles physiques du rotor sont sains, néanmoins la superposition des tronçons polaires fait apparaître des différences minimes entre les deux signaux, principalement aux extrema des oscillations des signaux. Comme expliqué précédemment, le signal de différence obtenu par soustraction point à point des valeurs des deux signaux superposés n'est donc pas parfaitement nul même avec des pôles sains. Dans l'exemple représenté, on peut déduire que le signal de différence atteint un maximum de l'ordre de 0,02 V dans une zone autour du point de mesure n° 400. Une difficulté du traitement du signal de différence consiste à pouvoir déterminer si un maximum observé sur le signal de différence traduit réellement un défaut de court-circuit sur un bobinage du rotor.

Dans le cas d'un défaut de court-circuit, le pôle du rotor comportant le défaut n'est pas connu a priori. Dans le cas d'un rotor comportant au moins deux paires de pôles, afin qu'au moins un signal de différence correspondant à une comparaison pôle à pôle puisse faire apparaître le défaut, il faut générer plusieurs signaux de différence dans lesquels aucun pôle n'est oublié. Une façon de générer les signaux de différence consiste à effectuer la différence entre le signal d'un tronçon polaire et le signal du tronçon polaire consécutif après son inversion, ce qui revient à effectuer une série de comparaisons entre pôles consécutifs. Puisque le signal est inversé entre un pôle pair et un pôle impair, la génération d'un signal de différence entre deux pôles consécutifs peut s'effectuer en additionnant point à point les valeurs algébriques des points de mesures de deux tronçons polaires consécutifs. Par exemple, le signal de différence (en l'occurrence Vs₁ -Vs₂) entre les deux premiers pôles consécutifs peut être calculé en additionnant les signaux (Vs₁ et -Vs₂) des deux premiers tronçons polaires.

De manière générale, le nombre Ns de signaux de différence à générer vérifie la relation Ns = Np - 1, où Np est le nombre de pôles de la machine électrique. Dans le cas d'un rotor à deux pôles, comme c'est généralement le cas pour des alternateurs de centrales thermiques, puisqu'il n'y a que deux pôles à comparer entre eux, un seul signal de différence peut être généré. Dans le cas d'un rotor à quatre pôles, à titre d'exemple, on pourra comparer entre eux les tronçons polaires des paires de tronçons polaires suivants : n°1 et n°2, n°2 et n°3, n°3 et n°4. Il n'est néanmoins pas exclu de générer un nombre de signaux de différence supérieur à Np - 1, mais cela n'est généralement pas nécessaire. Par exemple, on pourrait comparer également les tronçons polaires n°4 et n°1, de façon à avoir quatre signaux de différence, ce qui permettrait qu'un défaut de court-circuit sur un pôle quelconque fasse systématiquement apparaître un pic sur deux signaux de différence. A l'inverse, il n'est pas non plus exclu de générer seulement deux signaux de différence correspondant chacun à la comparaison des pôles d'une paire de pôles de même type pair ou impair, par exemple on pourra comparer entre eux les tronçons polaires des paires de tronçons polaires suivants : n°1 et n°3, n°2 et n°4. Dans ce cas, un défaut de court-circuit sur un pôle quelconque fera apparaître un pic sur un seul des deux signaux de différence.

Sur la FIG.5, on a représenté la superposition des signaux Vs₁, Vs₂, Vs₃ et Vs₄ correspondant à quatre tronçons polaires d'un signal de sonde découpé en un tour comme décrit ci-dessus. La fréquence d'échantillonnage est égale à 50 kHz, ce qui donne un pas d'échantillonnage égal à 2•10⁻⁵ s. Un tronçon polaire correspond à une durée de 10 ms puisque la fréquence du réseau est égale à 50 Hz, et représente donc 500 points de mesure à la fréquence d'échantillonnage de 50 kHz. Comme visible sur le détail entouré dans une zone de pic autour du point de mesure n° 400, une différence notable apparaît notamment entre le signal Vs₁ et le signal Vs₃ dans cette zone.

Sur la FIG.6, on a représenté trois signaux de différence G1, G2 et G3 correspondant chacun à la différence entre deux tronçons polaires consécutifs. Les signaux de différence G2 et G3 présentent chacun un pic dans la zone autour du point de mesure n° 400. Le pic du signal G3 présente la plus grande amplitude. Afin de déterminer si ce pic traduit un défaut réel du rotor, il convient d'établir un seuil de décision pour le signal de différence G3. Pour ceci, on calcule d'abord la valeur moyenne algébrique m et l'écart type e du signal G3. Avantageusement, ce calcul est effectué sur un signal de différence écrêté obtenu en supprimant du signal de différence des points MEᵢ situés dans des plages de valeurs extrêmes du signal. L'écrêtage du signal de différence permet de diminuer l'écart type e calculé du signal, ce qui améliore la décision pour l'identification d'un pic traduisant un défaut réel, comme détaillé plus loin.

Comme représenté sur la FIG.6, on écrête le signal de différence G3 en supprimant les points MEᵢ correspondant aux valeurs algébriques qui sont comprises entre une valeur extrême haute VGH du signal G3 et cette valeur VGH diminuée d'un certain pourcentage d'écrêtage P₁ de l'amplitude maximale AG du signal G3, ainsi que les points MEᵢ correspondant aux valeurs qui sont comprises entre une valeur extrême basse VGB du signal G3 et cette valeur VGB augmentée du même pourcentage d'écrêtage P₁ de l'amplitude maximale AG du signal G3. Le pourcentage d'écrêtage P₁ est ici choisi égal à 10%, et de manière générale peut être compris entre 2% et 20%.

Pour identifier les écarts importants entre les signaux de deux tronçons polaires consécutifs, un écart est jugé important si d'une part il existe une variation locale du signal de différence Gi très supérieure à l'écart-type e du signal écrêté, et si d'autre part cette variation est significative à l'échelle de la force électromotrice produite par la sonde de flux, c'est-à-dire si la variation locale est très supérieure à un certain ratio de l'amplitude maximale **A** du signal de sonde Vs (cf. FIG.1). Pour prendre en compte ces deux considérations, on calcule une valeur de seuil de décision S prenant en compte l'écart type e du signal de différence ainsi que l'amplitude maximale A du signal de sonde. La valeur de seuil de décision S peut avantageusement être calculée selon la relation suivante : S = k.√(e²+(A/K)²), où k et K sont des nombres entiers.

Le coefficient k, que nous appelons coefficient d'indication, est par exemple égal à 8. Le coefficient K, que nous appelons coefficient de ratio d'amplitude, est choisi de telle façon que le ratio 1/K soit égal à environ 0,5%. Ce coefficient de ratio d'amplitude K est donc choisi égal à 200. Une valeur de K choisie entre 180 et 220 est néanmoins possible. La demanderesse a étudié que la relation ci-dessus avec les valeurs susmentionnées des coefficients k et K constitue un compromis avantageux permettant d'obtenir des valeurs de seuils de décision S qui mènent à la détection très probable d'un défaut réel de court-circuit sur un bobinage du rotor et ne génèrent que très rarement des fausses détections, dès lors que certaines conditions sur la qualité de la mesure et de l'échantillonnage du signal de sonde sont respectées comme détaillé plus loin.

Comme représenté sur la FIG.4, le seuil de décision S s'adapte à l'amplitude maximale A du signal de sonde. En effet, quelle que soit la valeur de l'écart type e du signal de différence, le rapport S/k est substantiellement rehaussé si l'amplitude maximale A est augmentée. Un doublement de l'amplitude maximale A, cf. les courbes (A/K)² = 2 et (A/K)² = 8, entraîne presque un doublement du seuil de décision S pour les faibles valeurs d'écart type.

Une fois que le seuil de décision S est déterminé, on détermine une plage de diagnostic PM centrée sur la valeur moyenne algébrique m du signal de différence Gi et ayant pour largeur deux fois la valeur du seuil de décision S. Sur la FIG.7, on a représenté la plage de diagnostic PM concernant le signal de différence G3, pour les points de mesure jusqu'à la zone de pic entourée. La limite inférieure de la plage de diagnostic PM correspond à la valeur m-S. Le pic du signal de différence G3 descend sous cette limite inférieure et présente donc une série de points d'alerte MAᵢ qui se situent en dehors de la plage de diagnostic. Dans l'exemple représenté sur la FIG.7, la série de points d'alerte MAᵢ comprend 20 points d'alerte consécutifs MA₁ à MA₂₀ depuis le point de mesure n° 388 jusqu'au point n° 407. La pluralité de points d'alerte consécutifs constitue signifie que la partie de signal sortant de la plage de diagnostic n'est pas causée par des points isolés qui correspondraient à du bruit de la mesure. Le signalement d'un défaut de court-circuit est donc établi.

Il est à noter que dans l'exemple représenté sur les figures 5 à 7, le calcul d'une plage de diagnostic concernant le signal de différence G2 mène également à constater sur le pic du signal G2 dans la zone entourée une série de quelques points d'alerte consécutifs qui se situent en dehors de la plage de diagnostic. On constate donc que dans certains cas, les chances de détecter un défaut réel de court-circuit sont augmentées par le fait que deux signaux de différence Gi présentent chacun un pic significatif.

Le risque d'être confronté à un cas tangent dans lequel un défaut réel de court-circuit n'est pas détecté peut survenir si la qualité de la mesure du signal de sonde est insuffisante, comme cela s'est produit pour les mesures représentées sur la FIG.8 et la FIG.9. Comme visible sur la FIG.8, les signaux Vs₁ et Vs₂ présentent localement un certain écart dans une zone de points entre le point de mesure n°120 et le point n°140. Néanmoins, le signal de différence G1 correspondant à la différence entre les signaux Vs₁ et Vs₂ ne sort pas de la plage de diagnostic PM calculée. Le pic du signal G1 vers le point n°140 aurait été détecté si la valeur du coefficient d'indication k avait été abaissée à 7,8 au lieu de 8. Il apparaît clairement sur la FIG.9 que le signal n'est pas suffisamment quantifié, ce qui augmente l'écart type de chaque signal de différence et conduit donc à un seuil de décision S trop élevé. Un bruit de mesure élevé aurait également les mêmes conséquences.

De manière générale, il est souhaitable que la fréquence d'échantillonnage du signal de sonde soit au moins égale à 50 KHz, que l'échantillonnage utilise un convertisseur analogique/numérique ayant une résolution d'au moins 12 bits. En outre, il convient de régler le gain correctement de façon à explorer au maximum la plage de quantification, en évitant bien sûr les saturations. Par ailleurs, dans la plupart des cas, le dispositif de sonde de flux comprend une bobine radiale et une bobine tangentielle. Cela permet d'utiliser les deux signaux des deux bobines pour réaliser deux mesures par exemple simultanées qui seront traitées conjointement, ce qui renforce la fiabilité de la détection d'un défaut de court circuit. Il est en effet possible que le signal traité de la bobine radiale ne révèle pas de défauts, alors que le signal traité de la bobine tangentielle traduira un défaut réel, et réciproquement. Comme expliqué précédemment il est préférable d'enregistrer le signal de sonde sur au moins 1,25 tours afin d'identifier clairement un tour complet pour le découpage du signal en tronçons polaires.

Enfin, un bon positionnement de la sonde est important pour la qualité des signaux traités. En particulier, la position de la bobine tangentielle dans l'entrefer doit se situer le plus possible au milieu de l'entrefer. Une sonde trop près du stator donne un signal de bobine tangentielle atténué, et une sonde trop près du rotor soit risque d'être cassée par le passage du rotor. En outre, la bobine tangentielle doit être positionnée de manière à ce qu'elle perçoive 100% de la composante tangentielle du flux d'entrefer. Pour cela, l'anneau formé par la bobine tangentielle doit former idéalement un angle de 90° avec les lignes du champ d'induction. Généralement, la canule de la sonde peut tourner autour de son axe et comporte un repère permettant l'orientation correcte de la bobine tangentielle, ainsi qu'un repère de limite d'introduction de la sonde dans l'entrefer. Concernant la bobine radiale, sa position est affectée uniquement par la distance de la sonde vis-à-vis du rotor, puisque idéalement la bobine est centrée sur l'axe de la canule qui lui-même est orienté radialement vers l'axe du rotor.

Par ailleurs, une limite du procédé de détection selon l'invention apparaît en cas de mélange de défauts de court-circuit et d'excentricité dynamique, auquel cas les défauts de courts-circuits ne sont généralement pas détectés. En effet, les écarts globaux sur les différences pôle à pôle dus à l'excentricité vont prendre le pas sur les écarts locaux dus au court-circuit. Ainsi il est possible qu'un défaut d'excentricité cache un court-circuit. Néanmoins, un défaut d'excentricité dynamique va se caractériser par une mauvaise superposition des pôles, c'est-à-dire des tronçons polaires identifiés dans le signal mesuré par la sonde, sur une grande partie du signal d'un tronçon polaire. Par conséquent en observant la superposition des pôles obtenue conformément aux étapes réalisées dans le présent procédé de détection, il est possible de suspecter fortement la présence d'un défaut d'excentricité dynamique. Une évolution du procédé de détection selon l'invention consiste donc à rechercher la présence d'un défaut d'excentricité dynamique une fois les tronçons polaires identifiés et comparés entre eux, afin de rechercher la présence d'un défaut de court-circuit uniquement si aucun défaut d'excentricité dynamique n'est détecté.

## Revendications

1. Procédé de détection d'un défaut de court-circuit dans des bobinages d'un rotor d'une machine électrique tournante telle qu'un alternateur, utilisant des mesures de flux réalisées par une sonde disposée dans un entrefer de la machine, ledit procédé comprenant les étapes suivantes :
- l'échantillonnage d'un signal de sonde (Vs) mesuré par la sonde sur au moins un tour du rotor ;
- la génération d'au moins un signal de différence (Gi) représentatif de la différence point par point entre une superposition des mesures du signal de sonde (Vs) relatives à deux pôles distincts du rotor, afin de comparer pôle à pôle le signal de sonde mesuré ; et
- le traitement dudit signal de différence (Gi) de façon à pouvoir déterminer la présence éventuelle d'un défaut de court-circuit ;
**caractérisé en ce que** ladite étape de traitement du signal de différence (Gi) comprend les étapes suivantes :
- le calcul d'une valeur moyenne algébrique (m) et d'un écart type (e) dudit signal de différence (Gi) ;
- la détermination d'une amplitude maximale (A) du signal de sonde (Vs) ;
- le calcul d'une valeur de seuil de décision (S), prenant en compte ledit écart type (e) du signal de différence (Gi) ainsi que ladite amplitude maximale (A) du signal de sonde (Vs) ;
- la détermination d'une plage de diagnostic (PM) centrée sur ladite valeur moyenne algébrique (m) et ayant pour largeur deux fois ladite valeur du seuil de décision (S) ;
- le repérage d'au moins un éventuel point d'alerte (MAᵢ) correspondant à une valeur dudit signal de différence (Gi) qui se situe en dehors de ladite plage de diagnostic ; et
- le signalement d'un dit défaut de court-circuit dès lors qu'au moins un dit point d'alerte (MAᵢ) est repéré.

2. Procédé de détection selon la revendication 1, dans lequel on identifie un groupe fiable de points d'alerte dès lors qu'il est repéré au moins un nombre prédéterminé (Nc) de points d'alerte consécutifs (MA₁, MA₂,..., MA_{Nc}), et un dit défaut de court-circuit est signalé seulement si un dit groupe fiable de points d'alerte est identifié.

3. Procédé de détection selon la revendication 1 ou 2, dans lequel ledit signal de sonde (Vs) est enregistré sur un nombre de tours du rotor compris entre 1,25 et 2,5.

4. Procédé de détection selon l'une quelconque des revendications précédentes, dans lequel la fréquence d'échantillonnage du signal de sonde (Vs) est au moins égale à 50 KHz, et l'échantillonnage utilise un convertisseur analogique/numérique ayant une résolution d'au moins 12 bits.

5. Procédé de détection selon l'une quelconque des revendications précédentes, dans lequel ladite valeur de seuil de décision (S) vérifie la relation suivante :
S = k.√(e²+(A/K)²), où k et K sont des nombres entiers, e est l'écart type du signal de différence (Gi), et A est l'amplitude maximale du signal de sonde (Vs).

6. Procédé de détection selon la revendication 5, dans lequel k est égal à 8 et K est compris entre 180 et 220.

7. Procédé de détection selon l'une quelconque des revendications précédentes, dans lequel si un signal de top-tour est disponible on identifie dans le signal de sonde (Vs) chaque instant correspondant à un top-tour ; et si un signal de top-tour n'est pas disponible, on construit ce signal (TT0, TT1) par auto-corrélation des mesures du signal de sonde (Vs) effectuées sur au moins 1,25 tours, en connaissance de la fréquence théorique du réseau et du nombre de paires de pôles de la machine électrique, le top-tour étant identifié par les maxima de corrélation.

8. Procédé de détection selon la revendication 7, dans lequel on découpe le signal de sonde (Vs) par tours sur chaque période (Tr) entre deux top-tours consécutifs (TT0, TT1), et on procède à un ré-échantillonnage du signal afin que chaque tour découpé ait la même longueur en terme de nombre de points de mesure que la longueur théorique d'un tour sur la base de la fréquence théorique du réseau.

9. Procédé de détection selon la revendication 8, dans lequel un tour découpé du signal de sonde (Vs) est divisé par pôles en créant des tronçons polaires ayant chacun la longueur dudit tour découpé divisée par le nombres de pôles.

10. Procédé de détection selon la revendication 9, dans lequel deux tronçons polaires consécutifs sont comparés entre eux pour générer un dit signal de différence (Gi).

11. Procédé de détection selon l'une quelconque des revendications précédentes, dans lequel le calcul de la valeur moyenne (m) et de l'écart type (e) dudit signal de différence (Gi) est effectué sur un signal de différence écrêté obtenu en supprimant du signal de différence (Gi) des points (MEᵢ) situés dans des plages de valeurs extrêmes du signal.

12. Procédé de détection selon la revendication 11, dans lequel on supprime du signal de différence (Gi) les points (MEᵢ) correspondant aux valeurs algébriques qui sont comprises entre une valeur extrême haute (VGH) du signal de différence (Gi) et cette valeur extrême haute (VGH) diminuée d'un certain pourcentage d'écrêtage (P₁) de l'amplitude maximale (A) du signal de différence (Gi), ainsi que les points correspondant aux valeurs qui sont comprises entre une valeur extrême basse (VGB) du signal de différence (Gi) et cette valeur extrême basse (VGB) augmentée dudit pourcentage d'écrêtage (P₁) de l'amplitude maximale (A) du signal de différence (Gi), ledit pourcentage d'écrêtage (P₁) étant compris entre 2% et 20%.

13. Procédé de détection selon l'une quelconque des revendications précédentes, dans lequel on génère un nombre Ns de signaux de différence (G1, G2,... ; GNs), Ns vérifiant la relation Ns = Np - 1 où Np est le nombre de pôles de la machine électrique, et dans lequel un dit défaut de court-circuit est signalé dès lors que le traitement desdits signaux de différence (G1, G2,... ; GNs) fait apparaître au moins un dit point d'alerte (MAᵢ) sur au moins un dit signal de différence (Gi).

## Patentansprüche

1. Verfahren zur Erfassung eines Kurzschlussfehlers in Wicklungen eines Rotors einer drehenden elektrischen Maschine, wie eines Wechselstromgenerators, das Flussmessungen verwendet, die von einer in einem Luftspalt der Maschine angeordneten Sonde durchgeführt werden, wobei das Verfahren die folgenden Schritte enthält:
- die Abtastung eines Sondensignals (Vs), das von der Sonde über mindestens eine Umdrehung des Rotors gemessen wird;
- die Erzeugung mindestens eines Differenzsignals (Gi), das für die Punkt-für-Punkt-Differenz zwischen einer Überlagerung der Messungen des Sondensignals (Vs) in Bezug auf zwei verschiedene Pole des Rotors repräsentativ ist, um das gemessene Sondensignal Pol für Pol zu vergleichen; und
- die Verarbeitung des Differenzsignals (Gi) derart, dass das mögliche Vorhandensein eines Kurzschlussfehlers bestimmt werden kann;
**dadurch gekennzeichnet, dass** der Verarbeitungsschritt des Differenzsignals (Gi) die folgenden Schritte enthält:
- die Berechnung eines algebraischen Mittelwerts (m) und einer Standardabweichung (e) des Differenzsignals (Gi);
- die Bestimmung einer maximalen Amplitude (A) des Sondensignals (Vs);
- die Berechnung eines Entscheidungsschwellwerts (S), unter Berücksichtigung der Standardabweichung (e) des Differenzsignals (Gi) sowie der maximalen Amplitude (A) des Sondensignals (Vs);
- die Bestimmung eines Diagnosebereichs (PM), der auf den algebraischen Mittelwert (m) zentriert ist und als Breite das Doppelte des Entscheidungsschwellwerts (S) hat;
- die Kennzeichnung mindestens eines möglichen Warnpunkts (MAᵢ) entsprechend einem Wert des Differenzsignals (Gi), der außerhalb des Diagnosebereichs liegt; und
- die Meldung eines Kurzschlussfehlers, sobald mindestens ein Warnpunkt (MAᵢ) gekennzeichnet wird.

2. Erfassungsverfahren nach Anspruch 1, wobei eine zuverlässige Gruppe von Warnpunkten erkannt wird, sobald mindestens eine vorbestimmte Anzahl (Nc) von aufeinanderfolgenden Warnpunkten (MA₁, MA₂, ..., MA_{Nc}) gekennzeichnet wird, und ein Kurzschlussfehler nur gemeldet wird, wenn eine zuverlässige Gruppe von Warnpunkten erkannt wird.

3. Erfassungsverfahren nach Anspruch 1 oder 2, wobei das Sondensignal (Vs) über eine Anzahl von Umdrehungen des Rotors aufgezeichnet wird, die zwischen 1,25 und 2,5 liegt.

4. Erfassungsverfahren nach einem der vorhergehenden Ansprüche, wobei die Abtastfrequenz des Sondensignals (Vs) mindestens gleich 50 kHz ist, und die Abtastung einen Analog/Digital-Wandler verwendet, der eine Auflösung von mindestens 12 Bits hat.

5. Erfassungsverfahren nach einem der vorhergehenden Ansprüche, wobei der Entscheidungsschwellwert (S) die folgende Beziehung erfüllt:
S = k.√(e²+(A/K)²), wobei k und K ganze Zahlen sind, e die Standardabweichung des Differenzsignals (Gi) und A die maximale Amplitude des Sondensignals (Vs) ist.

6. Erfassungsverfahren nach Anspruch 5, wobei k gleich 8 ist und K zwischen 180 und 220 liegt.

7. Erfassungsverfahren nach einem der vorhergehenden Ansprüche, wobei, wenn ein Impuls/Umdrehung-Signal (top-tour) verfügbar ist, im Sondensignal (Vs) jeder einer Impuls/Umdrehung entsprechende Zeitpunkt erkannt wird; und wenn kein Impuls/Umdrehung-Signal verfügbar ist, dieses Signal (TT0, TT1) durch Autokorrelation der Messungen des Sondensignals (Vs) konstruiert wird, die über mindestens 1,25 Umdrehungen durchgeführt werden, in Kenntnis der theoretischen Frequenz des Netzes und der Anzahl von Polpaaren der elektrischen Maschine, wobei die Impuls/Umdrehung durch die Korrelationsmaxima erkannt wird.

8. Erfassungsverfahren nach Anspruch 7, wobei das Sondensignal (Vs) pro Umdrehungen über jede Periode (Tr) zwischen zwei aufeinanderfolgenden Impuls/Umdrehungen (TT0, TT1) zerhackt wird, und eine erneute Abtastung des Signals durchgeführt wird, damit jede zerhackte Umdrehung die gleiche Länge bezüglich der Anzahl von Messpunkten hat wie die theoretische Länge einer Umdrehung auf der Basis der theoretischen Frequenz des Netzes.

9. Erfassungsverfahren nach Anspruch 8, wobei eine zerhackte Umdrehung des Sondensignals (Vs) durch Pole dividiert wird, indem Polabschnitte erzeugt werden, die je die Länge der zerhackten Umdrehung dividiert durch die Anzahl von Polen haben.

10. Erfassungsverfahren nach Anspruch 9, wobei zwei aufeinanderfolgende Polabschnitte miteinander verglichen werden, um ein Differenzsignal (Gi) zu erzeugen.

11. Erfassungsverfahren nach einem der vorhergehenden Ansprüche, wobei die Berechnung des Mittelwerts (m) und der Standardabweichung (e) des Differenzsignals (Gi) an einem spitzenbegrenzten Differenzsignal durchgeführt wird, das durch Entfernen der Punkte (MEᵢ) aus dem Differenzsignal (Gi) erhalten wird, die sich in Endwertbereichen des Signals befinden.

12. Erfassungsverfahren nach Anspruch 11, wobei aus dem Differenzsignal (Gi) die Punkte (MEᵢ), die den algebraischen Werten entsprechen, die sich zwischen einem hohen Endwert (VGH) des Differenzsignals (Gi) und diesem hohen Endwert (VGH) verringert um einen gewissen Spitzenbegrenzungsprozentsatz (P₁) der maximalen Amplitude (A) des Differenzsignals (Gi) befinden, sowie die Punkte entfernt werden, die den Werten entsprechen, die zwischen einem tiefen Endwert (VGB) des Differenzsignals (Gi) und diesem tiefen Endwert (VGB) erhöht um den Spitzenbegrenzungsprozentsatz (P₁) der maximalen Amplitude (A) des Differenzsignals (Gi) liegen, wobei der Spitzenbegrenzungsprozentsatz (P₁) zwischen 2% und 20% liegt.

13. Erfassungsverfahren nach einem der vorhergehenden Ansprüche, wobei eine Anzahl Ns von Differenzsignalen (G1, G2, ...; GNs) erzeugt wird, wobei Ns die Beziehung Ns = Np - 1 erfüllt, in der Np die Anzahl von Polen der elektrischen Maschine ist, und wobei ein Kurzschlussfehler gemeldet wird, sobald die Verarbeitung der Differenzsignale (G1, G2, ...; GNs) mindestens einen Warnpunkt (MAᵢ) auf mindestens einem Differenzsignal (Gi) auftreten lässt.

## Claims

1. Method for detecting a short circuit fault in the windings of a rotor of a rotating electric machine such as an alternator, using measurements of flux made by a probe positioned in an air gap of the machine, said method comprising the following steps:
- sampling a probe signal (Vs) measured by the probe over at least one rotation of the rotor;
- generating at least one difference signal (Gi) representative of the point by point difference between a superposition of the measurements of the probe signal (Vs) relative to two distinct poles of the rotor, in order to compare the probe signal measured pole to pole; and
- processing said difference signal (Gi) in such a way as to be able to determine the possible presence of a short circuit fault;
**characterised in that** said step of processing the difference signal (Gi) comprises the following steps:
- calculating an algebraic mean value (m) and a standard deviation (e) of said difference signal (Gi);
- determining a maximum amplitude (A) of the probe signal (Vs);
- calculating a decision-threshold value (S) that takes into account said standard deviation (e) of the difference signal (Gi) and said maximum amplitude (A) of the probe signal (Vs);
- determining a diagnostic range (PM) centred on said algebraic mean value (m) and having a size of twice said decision-threshold value (S);
- detecting at least one possible alert point (MAᵢ) corresponding to a value of said difference signal (Gi) that is located outside of said diagnostic range; and
- signalling a said short circuit fault as soon as at least one said alert point (MAᵢ) is detected.

2. Detection method according to claim 1, wherein a reliable group of alert points is identified as soon as at least a predetermined number (Nc) of consecutive alert points (MA₁, MA₂,..., MA_{Nc}) is detected, and a said short circuit fault is signalled only if a said reliable group of alert points is identified.

3. Detection method according to claim 1 or 2, wherein said probe signal (Vs) is recorded over a number of rotations of the rotor between 1.25 and 2.5.

4. Detection method according to any of the previous claims, wherein the sampling frequency of the probe signal (Vs) is at least equal to 50 KHz and the sampling uses an analogue/digital converter having a resolution of at least 12 bits.

5. Detection method according to any of the previous claims, wherein said decision-threshold value (S) satisfies the following relation:
S = k.√(e²+(A/K)²), where k and K are whole numbers, e is the standard deviation of the difference signal (Gi), and A is the maximum amplitude of the probe signal (Vs).

6. Detection method according to claim 5, wherein k is equal to 8 and K is between 180 and 220.

7. Detection method according to any of the previous claims, wherein if a start-of-rotation signal is available, each instant in the probe signal (Vs) corresponding to a start of rotation is identified, and if a start-of-rotation signal is not available, this signal (TT0, TT1) is constructed via auto-correlation of the measurements of the probe signal (Vs) made over at least 1.25 rotations, with knowledge of the theoretical frequency of the network and the number of pairs of poles of the electric machine, the start of rotation being identified by the maxima of correlation.

8. Detection method according to claim 7, wherein the probe signal (Vs) is divided into rotations for each period (Tr) between two consecutive starts-of-rotation (TT0, TT1), and a resampling of the signal is carried out so that each rotation cut out has the same length in terms of number of measurement points as the theoretical length of a rotation based on the theoretical frequency of the network.

9. Detection method according to claim 8, wherein a rotation cut out from the probe signal (Vs) is divided by poles, creating polar sections each having the length of said rotation cut out divided by the number of poles.

10. Detection method according to claim 9, wherein two consecutive polar sections are compared to generate a said difference signal (Gi).

11. Detection method according to any of the previous claims, wherein the calculation of the mean value (m) and of the standard deviation (e) of said difference signal (Gi) is carried out on a clipped difference signal obtained by eliminating, from the difference signal (Gi), points (MEᵢ) located in extreme ranges of values of the signal.

12. Detection method according to claim 11, wherein the points (MEᵢ) corresponding to the algebraic values that are between an extreme high value (VGH) of the difference signal (Gi) and this extreme high value (VGH) reduced by a certain clipping percentage (P₁) of the maximum amplitude (A) of the difference signal (Gi), as well as the points corresponding to the values that are between an extreme low value (VGB) of the difference signal (Gi) and this extreme low value (VGB) increased by said clipping percentage (P₁) of the maximum amplitude (A) of the difference signal (Gi), are removed from the difference signal (Gi), and said clipping percentage (P₁) is between 2% and 20%.

13. Detection method according to any of the previous claims, wherein a number Ns of difference signals (G1, G2,...; GNs) is generated, with Ns satisfying the relation Ns = Np - 1, where Np is the number of poles of the electric machine, and a said short circuit fault is signalled as soon as the processing of said difference signals (G1, G2,...; GNs) reveals at least one said alert point (MAᵢ) in at least one said difference signal (Gi).
